# EUROPEAN PATENT APPLICATION

(11) **EP 1 901 539 A1**
(43) Date of publication of application: **19.03.2008**
(21) Application number: 06019189.7
(22) Date of filing: 13.09.2006
(51) Int. Cl.: H04M 11/06

(54) **DSL splitter**

(71) Applicant: YCL ELECTRONICS CO., LTD., Feng Shan City, Kaohsiung County (TW)
(72) Inventor: Chen, Yung-Sheng, Feng Shan City, Kaohsiung County (TW); Liu, Wen-Chung, Kaohsiung County (TW)
(74) Representative: GROSSE BOCKHORNI SCHUMACHER

(57) **Abstract**

A signal splitter (1, 1') includes a low-pass filter circuit (11) having first and second input ends (111, 112) connected electrically and respectively to first and second terminals (131, 132) of a first connecting port (13), and first and second output ends (113, 114) connected electrically and respectively to first and second terminals (121, 122) of a second connecting port (12) for permitting a low-frequency component of an incoming signal in an incoming telephone line to pass therethrough to the second connecting port (12). A high-frequency impedance matching circuit (14) has a resistor (R) and a capacitor (C1) coupled in series across the first and second terminals (121, 122) of the second connecting port (12), a first inductor (141) that interconnects the first terminal (121) of the second connecting port (12) and the first output end (113) of the low-pass filter circuit (11), and a second inductor (142) that interconnects the second terminal(122) of the second connecting port (12) and the second output end (114) of the low-pass filter circuit (11).

## Description

The invention relates to a signal splitter, more particularly to a signal splitter capable of reducinq cross-talk phenomenon.

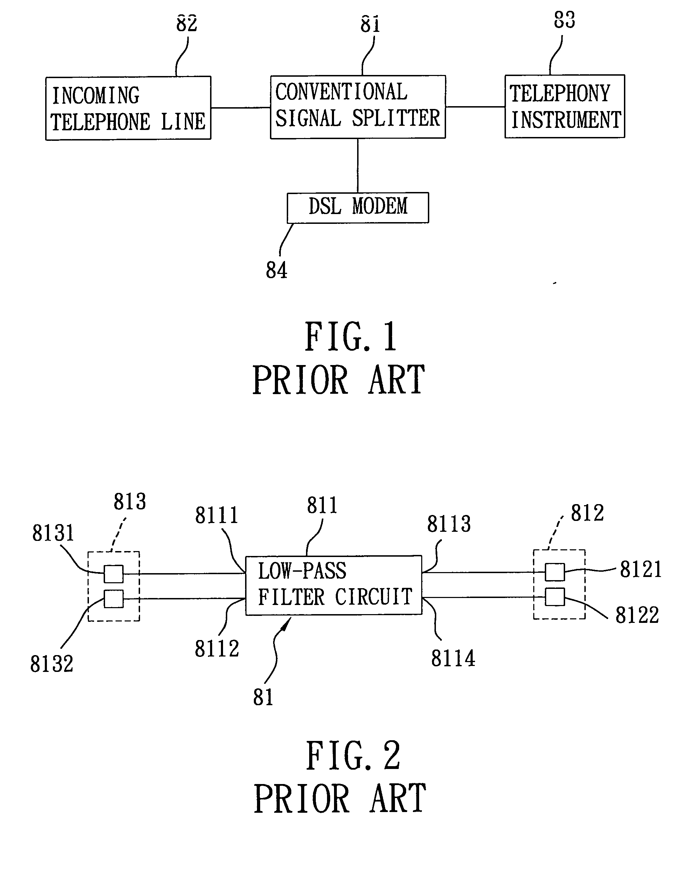

Figures 1 and 2 illustrate a conventional signal splitter 81 that can be coupled among an incoming telephone line 82, a telephony instrument 83 and a digital subscriber line (DSL)modem 84, andthatincludes a first connecting port 813, a second connecting port 812 and a low-pass filter circuit 811. The first connecting port 813 is to be coupled to the incoming telephone line 82, and has first and second terminals 8131, 8132. The second connecting port 812 is to be coupled to the telephony instrument 83, and has first and second terminals 8121, 8122. The low-pass filter circuit 811 has first and second input ends 8111, 8112 connected electrically and respectively to the first and second terminals 8131, 8132 of the first connecting port 813, and first and second output ends 8113, 8114 connected electrically and respectively to the first and second terminals 8121, 8122 of the second connecting port 812. The low-pass filter circuit 811 is capable of permitting a low-frequency component of an incoming signal in the incoming telephone line 82 to pass therethrough to the second connecting port 812 in a known manner.

It is noted that, since the first connecting port 813 is disposed adjacent to the second connecting port 812 due to physical restrictions imposed by the environment of application, a high-frequency noise signal is easily induced by a high-frequency component of the incoming signal in the incoming telephone line 82 upon the second connecting port 812. Due to the induced high-frequency noise signal, cross-talk phenomenon is unavoidable.

Therefore, the object of the present invention is to provide a signal splitter that can overcome the aforesaid drawback of the prior art.

According to the present invention, a signal splitter comprises:
a first connecting port adapted to be coupled to an incoming telephone line and having first and second terminals;
a second connecting port adapted to be coupled to a telephony instrument and having first and second terminals;
a low-pass filter circuit having first and second input ends connected electrically and respectively to the first and second terminals of the first connecting port, and first and second output ends connected electrically and respectively to the first and second terminals of the second connecting port, the low-pass filter circuit being capable of permitting a low-frequency component of an incoming signal in the incoming telephone line to pass therethrough to the second connecting port; and
a high-frequency impedance matching circuit unit including a high-frequency impedance matching circuit that has a resistor and a capacitor coupled in series across the first and second terminals of the second connecting port, a first inductor that interconnects the first terminal of the second connecting port and the first output end of the low-pass filter circuit, and a second inductor that interconnects the second terminal of the second connecting port and the second output end of the low-pass filter circuit.

Other features and advantages of the present invention will become apparent in the following detailed description of the preferred embodiments with reference to the accompanying drawings, of which:
Figure 1 is a schematic circuit block diagram illustrating a connecting relationship of a conventional signal splitter with an incoming telephone line, a telephony instrument and a DSL modem;
Figure 2 is a schematic circuit block diagram of the conventional signal splitter;
Figure 3 is a schematic circuit block diagram illustrating the first preferred embodiment of a signal splitter according to the present invention; and
Figure 4 is a schematic circuit block diagram illustrating the second preferred embodiment of a signal splitter according to the present invention.

Before the present invention is described in greater detail, it should be noted that like elements are denoted by the same reference numerals throughout the disclosure.

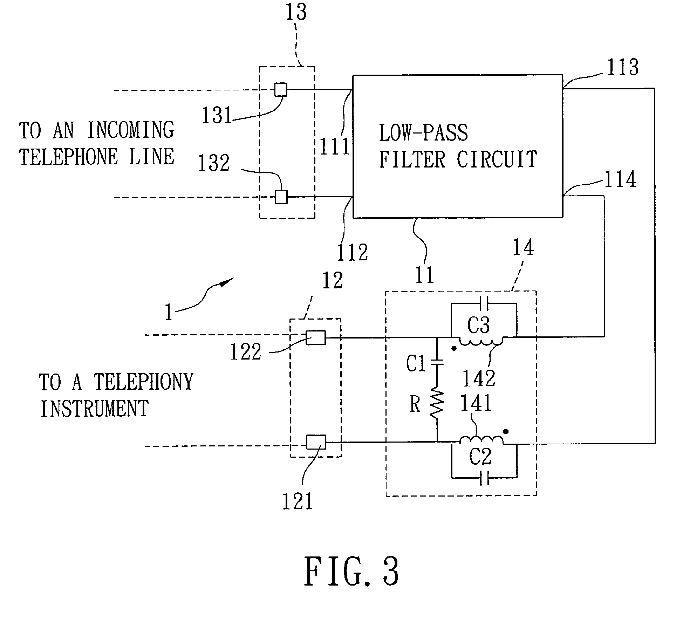

Referring to Figure 3, the first preferred embodiment of a signal splitter 1 according to the present invention is shown to include a first connecting port 13, a second connecting port 12, a low-pass filter circuit 11, and a high-frequency impedance matching unit.

The first connecting port 13 is adapted to be coupled to an incoming telephone line, and has first and second terminals 131, 132.

The second connecting port 12 is adapted to be coupled to a telephony instrument, and has first and second terminals 121, 122.

The low-pass filter circuit 11 has first and second input ends 111, 112 connected electrically and respectively to the first and second terminals 131, 132 of the first connecting port 13, and first and second output ends 113, 114 connected electrically and respectively to the first and second terminals 121, 122 of the second connecting port 12. The low-pass filter circuit 11 is capable of permitting a low-frequency component of an incoming signal in the incoming telephone line to pass therethrough to the second connecting port 12 in a known manner.

Since the feature of the invention does not reside in the configuration of the low-pass filter circuit 11, which is conventional details of the same are omitted herein for the sake of brevity.

In this embodiment, the high-frequency impedance matching circuit unit includes a high-frequency impedance matching circuit 14 that has a resistor (R) and a first capacitor (C1) coupled in series across the first and second terminals 121, 122 of the second connecting port 12, a first inductor 141 that interconnects the first terminal 121 of the second connecting port 12 and the first output end 113 of the low-pass filter circuit 11, a second inductor 142 that interconnects the second terminal 122 of the second connecting port 12 and the second output end 114 of the low-pass filter circuit 11, a second capacitor (C2) connected across the first inductor 141, and a third capacitor (C3) connected across the second inductor 142. For the high-frequency impedance matching circuit unit, impedances of the first and second inductors 141, 142, the first to third capacitors (C1, C2, C3), and the resistor (R) can be adjusted so that impedance matching between the high-frequency impedance matching circuit unit, and a high-frequency noise signal induced by a high-frequency component of the incoming signal in the incoming telephone line upon the second connecting port 12 is obtained. As such, the high-frequency noise signal induced upon the second connecting port 12 can be reduced, thereby minimizing the effect of cross-talk phenomenon.

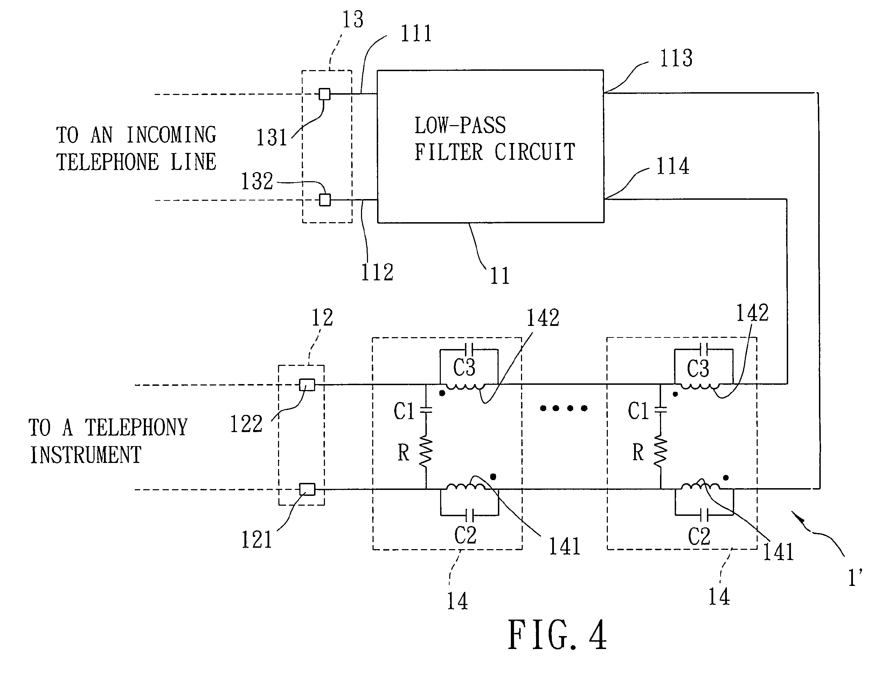

Figure 4 illustrates the second preferred embodiment ofₒ a signal splitter 1' according to this invention, which is a modification of the first preferred embodiment. In this embodiment, the high-frequency impedance matching circuit unit is composed of a plurality of the high-frequency impedance matching circuits 14 having a cascade connection between the first and second terminals 121, 122 of the second connecting port 12, and the first and second output ends 113, 114 of the low-pass filter circuit 11.

The signal splitter 1, 1' of this invention further includes a modem interface (not shown) for coupling with a DSL modem, such as an Asymmetric Digital Subscriber Line (ADSL) modem, an Integrated Digital Subscriber Line (IDSL) modem, a High-bit-rate Digital Subscriber Line (HDSL) modem, a Single-pair Digital Subscriber Line (SDSL) modem, a Very High Data Rate Subscriber Line (VDSL) modem, etc. The modem interface permits the high-frequency component of the incoming signal in the incoming telephone line to pass therethrough to the DSL modem. Since the feature of the invention does not reside in the configuration of the modem interface, which is conventional, details of the same are omitted herein for the sake of brevity.

## Claims

1. A signal splitter (1, 1'), **characterized by**:
a first connecting port (13)adapted to be coupled to an incoming telephone line and having first and second terminals (131, 132);
a second connecting port (12)adapted to be coupled to a telephony instrument and having first and second terminals (121, 122);
alow-passfiltercircuit (11) having first and second input ends (111, 112) connected electrically and respectively to said first and second terminals (131, 132) of said first connecting port (13), and first and second output ends (113, 114) connected electrically and respectively to said first and second terminals (121, 122) of said second connecting port (12), said low-pass filter circuit (11) being capable of permitting a low-frequency component of an incoming signal in the incoming telephone line to pass therethrough to said second connecting port (12); and
a high-frequency impedance matching circuit unit including a high-frequency impedance matching circuit (14) that has a resistor (R) and a first capacitor (C1) coupled in series across said first and second terminals (121, 122) of said second connecting port (12), a first inductor (141) that interconnects said first terminal (121) of said second connecting port (12) and said first output (113) end of said low-pass filter circuit (11), and a second inductor (142) that interconnects said second terminal (122) of said second connecting port (12) and said second output end (114) of said low-pass filter circuit (11).

2. The signal splitter (1, 1') as claimed in Claim 1, **characterized in that** said high-frequency impedance matching circuit (14) further has a second capacitor (C2) connected across said first inductor (141), and a third capacitor (C3) connected across said second inductor (142).

3. The signal splitter (1') as claimed in Claim 1, **characterized in that** said high-frequency impedance matching circuit unit is composed of a plurality of said high-frequency impedance matching circuits (14) having a cascade connection between said second connecting port (12) and said low-pass filter circuit (11).
